# EUROPÄISCHE PATENTSCHRIFT

(11) **EP 0 975 206 B1**
(45) Veröffentlichungstag und Bekanntmachung des Hinweises auf die Patenterteilung: **28.04.2004**
(21) Anmeldenummer: 99114052.6
(22) Anmeldetag: 20.07.1999
(51) Int. Cl.: H05K 5/04

(54) **Container für ein Schienenfahrzeug zur Installation von elektronischen und elektrischen Geräten**
Housing for the installation of electronic and electrical apparatuses in a railway vehicle
Coffret pour l'installation d'appareils électriques et électroniques dans un véhicule ferroviaire

(30) Priorität: 21.07.1998 DE 19832740
(43) Veröffentlichungstag der Anmeldung: 26.01.2000
(73) Patentinhaber: DaimlerChrysler AG, 70567 Stuttgart (DE)
(72) Erfinder: Zengerle, Manfred, Dipl.-Ing., 67280 Ebertsheim (DE)
(74) Vertreter: Akers, Noel James

(56) Entgegenhaltungen:
- DE-A- 2 424 722
- DE-A- 19 545 448
- DE-U- 8 611 965

## Beschreibung

Die Erfindung bezieht sich auf einen Container für ein Schienenfahrzeug zur Installation von elektrischen und elektronischen Geräten gemäß dem Oberbegriff des Anspruchs 1. Der erfindungsgemäße Container kann insbesondere zur Aufnahme von Stromrichtergeräten verwendet werden.

Bei Schienenfahrzeugen, insbesondere bei Nahverkehrsfahrzeugen, ist es allgemein bekannt, Stromrichtergeräte und zugehörige Baukomponenten in einem Container zu installieren, der im Unterflurbereich, im Dachbereich oder in einem Maschinenraum des Fahrzeuges montiert wird. Die allgemein bekannten Container sind aus einzelnen Blechen aufgebaut, wobei kostenaufwendige Konstruktionen erforderlich sind, um die notwendige mechanische Stabilität und Dichtigkeit gegen Feuchtigkeit und Staub sicherzustellen.

Aus der DE 2424722 B2 ist ein Gehäuse für Geräte der elektrischen Meß- und Nachrichtentechnik bekannt, bei dem ein aus den Seitenteilen, dem Gehäuseboden und der Oberseite bestehender Mantel oder ein Teil desselben aus einem Band geformt ist. Das Band weist Quernuten auf, die die Bandstärke bis auf einen kleinen Materialsteg verringern und das Band in Bandabschnitte unterteilt. Im Bereich der Quernuten ist das Band abwinkelbar, so daß die Materialstege Gehäusekanten bilden. Das Band weist weiterhin durchgehende Längsnuten für die randseitige Aufnahme und Halterung von plattenförmigen Baugruppenträgern auf, die zwischen einer Frontplatte und einer Gehäuserückwand angeordnet sind. Nachteilig ist bei diesem bekannten Gehäuse die mangelhafte Abfuhr der von den elektronischen Bauteilen erzeugten Wärme, die wiederum die Funktionsfähigkeit der Bauteile beeinträchtigt. Des weiteren ist die Verkabelung der plattenförmigen Baugruppenträger schwierig, da für die Kabel nur wenig Raum zur Verfügung steht.

Aus der DE 19709460 A1 ist ein Freiluftgehäuse zur Aufnahme von Elekronikbauteilen bekannt, das sich aus einer inneren Gehäusestruktur, die die Bauteile hermetisch dicht umschließt, und einer äußeren Gehäusestruktur, die an der inneren Gehäusestruktur unter Ausbildung eines Hohlraumes angeordnet ist, zusammensetzt. Die äußere Gehäusestruktur wird von Hohlprofilschienen gebildet, die an der inneren Gehäusestruktur lösbar befestigt sind. Trotzdem der Hohlraum zur Kühlung der Bauteile beiträgt, ist die Wärmeabfuhr noch immer ungenügend. Außerdem erreicht man mit den bekannten Freiluftgehäuse nicht die notwendige Kompaktheit bzw. geringe Baugröße, die für den Einbau des Gehäuses in den Unterflur- oder Dachbereich eines Schienenfahrzeuges erforderlich ist. Außerdem führt die bekannte Bauweise zu einer geringen mechanischen Stabilität des Gesamtgehäuses.

Der Erfindung liegt somit die Aufgabe zugrunde, einen Container für ein Schienenfahrzeug zur Installation von elektrischen und elektronischen Geräten der eingangs genannten Art anzugeben, der eine verbesserte Wärmeabfuhr ermöglicht und trotzdem die erforderliche Kompaktheit und mechanische Stabilität und Dichtigkeit gegenFeuchtigkeit und Staub aufweist, wobei gleichzeitig ein einfaches Verdrahten der im Container befindlichen elektronischen Bauteile ermöglicht werden soll.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß durch die Integration eines Kühlmittelkanals mit geschlossenem Querschnitt in das Strangpreßprofil ein sehr kompakter Aufbau des Containers bei gleichzeitiger Kühlung der Bauteile erreicht wird. Der erfindungsgemäße Container kann sowohl im Unterflurbereich des Schienenfahrzeuges als auch im Dachbereich als auch im Maschinenraum montiert werden und ist hinsichtlich der gewünschten Dimensionierung (Länge/Breite/Höhe) äußerst flexibel handhabbar.

Des weiteren entsteht nach dem Biegen des Strangpreßprofils ein geschlossener Kühlmittelkanal, der den Container umspannt. Mit Hilfe der Kühlkanäle wird ein geräteinterner Kühlkreislauf gebildet, wobei das Kühlmittel mit Druck beaufschlagt werden kann, so daß die Wärmeabfuhr verstärkt wird.

Ein weiterer mit der Erfindung erzielbarer Vorteil besteht darin, daß durch die Biegung des Strangpreßprofils in den Kantenbereichen zusätzliche Schweiß- oder Schraubstellen entfallen, welche die Gefahr von Undichtigkeiten des Gehäuseinnenraumes zur Umgebung mit sich bringen, wodurch Verschmutzungen eingebracht und Korrosion gefördert werden. Außerdem ist die gewünschte hohe mechanische Festigkeit des Containers aufgrund des Einsatzes des Strangpreßprofiles mit geschlossenen Querschnitten mit vergleichsweise geringem Aufwand erzielbar, insbesondere, wenn man ein aus einzelnen herkömmlichen Blechteilen zusammengesetztes und verschweißtes Gehäuse zum Vergleich heranzieht. Auch bei sehr flacher Bauweise ergibt sich eine sehr hohe mechanische Steifigkeit. Da nur wenig Schweißstellen erforderlich sind bzw. bei Einsatz von geeigneten Winkelstücken im Kantenbereich auf Schweißarbeiten weitgehend verzichtet werden kann, ergibt sich nur sehr wenig Verzug bei der Montage.

Die Erfindung wird nachstehend anhand der in der schematischen Zeichnung dargestellten Ausführungsbeispiele näher erläutert. Es zeigen:
- Fig. 1: eine perspektivische Darstellung des erfindungsgemäßen Containers ohne Deckel und Rückwand,
- Fig. 2: eine Vorderansicht des Containers von Fig. 1,
- Fig. 3: einen Ausschnitt der Seitenansicht eines Strangpreßprofils vor dem Biegen,
- Fig. 4: einen Schnitt längs der Schnittebene I in Fig. 1 durch den erfindungsgemäßen Container mit Deckel und Rückwand und
- Fig. 5: einen Schnitt durch das Strangpreßprofil zur Herstellung des erfundungsgemäßen Containers.

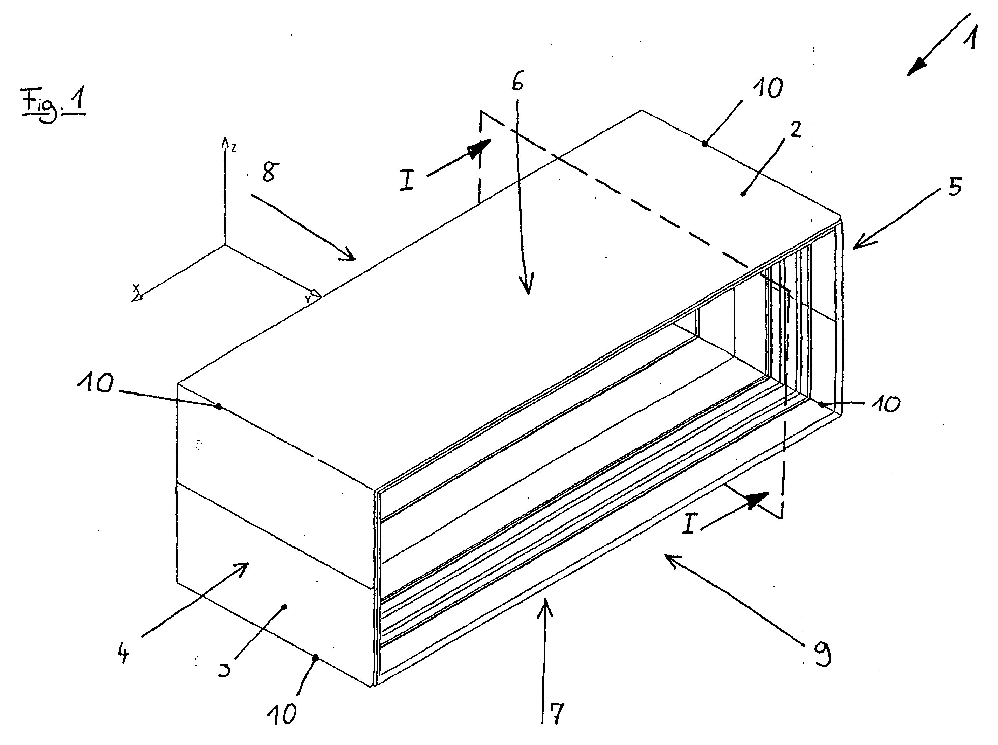

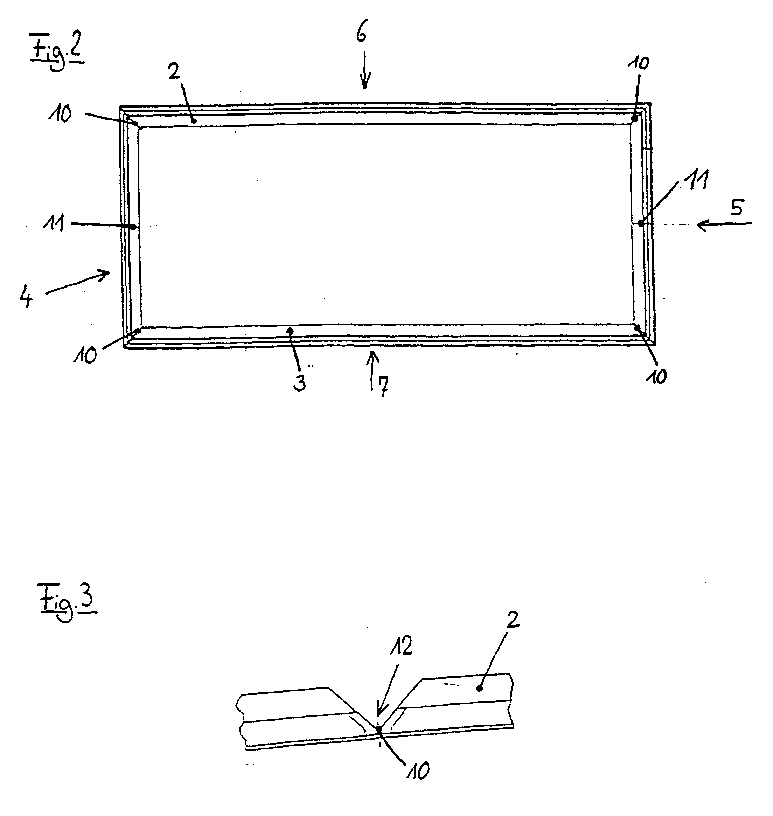

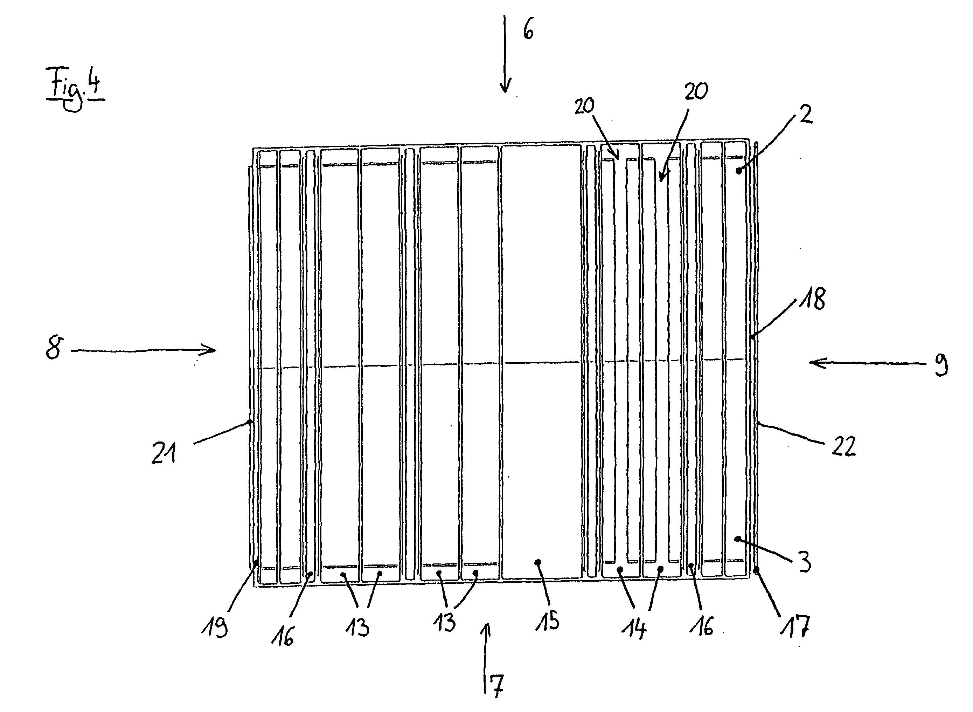

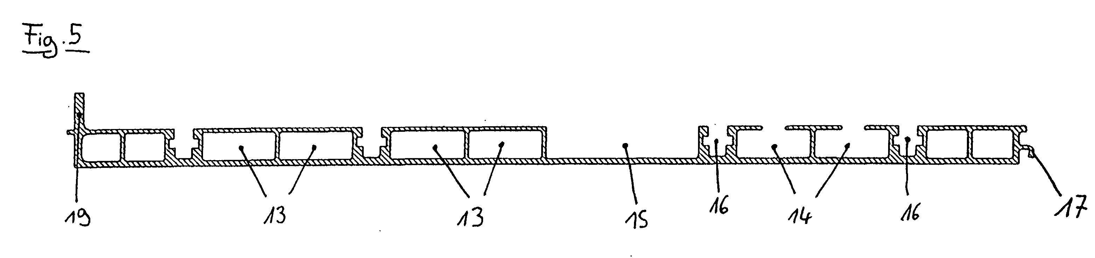

Fig. 1 zeigt eine perspektivische Darstellung des erfindungsgemäßen Containers. Der Container 1 ist aus vier Hauptkomponenten zusammengesetzt, nämlich einem Oberteil 2, einem Unterteil 3, einer Rückwand 21 und einem Deckel 22, wobei die letztgenannten beiden Komponenten in Fig. 4 dargestellt sind. Das Oberteil 2 bildet mit dem Unterteil 3 die Seitenflächen 4 und 5 sowie die Dach- und Bodenfläche 6 und 7 des Containers 1 aus. Die Rückwand 21 bzw. der Deckel 22 sind aus flachen Blechen, vorzugsweise aus Aluminium, gebildet, und verschließen die Rückseite 8 bzw. die Vorderseite 9 des Containers 1. Das Oberteil 2 wie auch das Unterteil 3 besteht aus einem speziellen, nachstehend im einzelnen beschriebenen Aluminium-Strangpreßprofil. Bei kleinerer Ausführung des Containers kann auch eine Variante verwendet werden, bei das Oberteil 2 und Unterteil 3 zu einem einzigen Teil zusammengefaßt sind. Sowohl bei der einteiligen wie auch bei der zweiteiligen Ausführung, bei der Unter- und Oberteil 2,3 vorgesehen sind, erfolgt die Verbindung der Aluminium-Strangpreßprofile vorzugsweise nicht im Kantenbereich 10, sondern längs einer Seitenfläche 4,5.

In Fig. 2 ist eine Vorderansicht des Containers von Fig. 1 dargestellt. Sowohl das Oberteil 2 als auch das Unterteil 3 sind jeweils einstückig U-förmig gebogen. Wie zu erkennen ist, müssen die Aluminium-Strangpreßprofile zunächst bearbeitet und danach um 90° abgebogen werden, um die jeweils rechtwinkligen Abwinkelungen in den Kantenbereichen 10 zu ermöglichen. Zur Erzielung der gewünschten mechanischen Stabilität sind die Kantenbereiche vorzugsweise verschweißt oder unter Einsatz passender Winkelstücke verschraubt. Die Verbindung von Oberteil 2 und Unterteil 3 erfolgt an deren Stirnflächen 11 vorzugsweise durch Verschweißen, wobei die Stirnflächen 11 im Bereich der Seitenflächen 4,5 angeordnet sind.

In Fig. 3 ist hierzu am Beispiel des Oberteils 2 die Bearbeitung des Aluminium-Strangpreßprofils zur Schaffung eines Kantenbereichs 10 dargestellt. Die Aluminium-Strangpreßprofile werden in den Kantenbereichen 10 quer zur Preßrichtung bis zur Grundmaterialstärke mit einem rechtwinkligen, V-förmigen Einschnitt 12 versehen, vorzugsweise durch Fräsen.

Fig. 4 zeigt einen Schnitt durch den Container von Fig. 1 entlang der Schnittebene 1. Das zur Bildung der Seitenflächen 4,5, der Dachfläche 6 und der Bodenfläche 7 eingesetzte Aluminium-Strangpreßprofil besitzt eine genau an die Erfordernisse des Containers 1 angepaßte spezielle Struktur mit mindestens einem Kühlmittelkanal 13, mindestens einem Kabelkanal 14, mindestens einem Kanal 15 zur Aufnahme von Stromschienen, mindestens einer Nut 16 zur Befestigung von gehäuseinternen Zwischenwänden, einer deckelseitigen Kante 17 zur Einhängung eines Deckelscharniers, einem deckelseitigen Dichtkragen 18 und einem rückwandseitigen Flansch 19.

Der mindestens eine Kühlmittelkanal 13 ist mit geschlossenem Querschnitt versehen und an den Kantenbereichen 10 vorzugsweise durchgehend verbunden, wobei die Abdichtung im Kantenbereich 10 bei Einsatz von Luft als Kühlmittel mittels Silikon erfolgen kann. Bei Einsatz einer mit vorgegebenem Druck beaufschlagten Kühlflüssigkeit wird der Kühlmittelkanal 13 durch Verschweißung kühlmitteldicht verbunden. Mit Hilfe der Kühlmittelkanäle 13 wird ein geräteintemer Kühlkreislauf, vorzugsweise Luft-Kühlkreislauf, gebildet. Die in einzelnen im Innenraum des Containers installierten Komponenten produzierte und abgestrahlte Wärmeenergie wird durch den geräteinternen Kühlkreislauf aufgenommen und über die Oberfläche des Containers an die Außenatmosphäre abgegeben. Hierdurch wird die Entstehung unzulässig hoher Temperaturen innerhalb des Containers 1 verhindert.

Der mindestens eine Kabelkanal 14 weist eine durchgehende, zum Innenraum des Containers gerichtete Öffnung 20 auf und ermöglicht derart das Einlegen und Führen von elektrischen Leitungen, die innerhalb des Containers 1 zwischen den einzelnen Komponenten zu verlegen sind.

Der nasenförmige, umlaufende Dichtkragen 18 drückt gegen einen im Deckel 22 eingelegtes Dichtprofil, welches beispielsweise aus Gummi besteht. Auf diese Art wird eine sehr gute Dichtwirkung erzielt.

Der umlaufende Flansch 19 dient zum einen zur Befestigung der Rückwand 21, wobei vorzugsweise ein eingelegtes Dichtprofil für die Abdichtung des Gehäuseinnenraums vorgesehen ist, zum anderen werden über diesen Flansch 19 die Kräfte der installierten Komponenten in die Gehäusestruktur eingeleitet.

Fig. 5 zeigt in vergrößerter Darstellung das Strangpreßprofil zur Herstellung des Containers 1. Es sind in erster Linie die Kühlmittelkanäle 13, die Kabelkanäle 14, den Kanal 15 zur Aufnahme von Stromschienen, die Nuten 16 zur Befestigung von gehäuseinternen Zwischenwänden, die deckelseitige Kante 17 zur Einhängung eines Deckelscharniers und der rückwandseitige Flansch 19 zu erkennen.

## Patentansprüche

1. Container für ein Schienenfahrzeug zur Installation von elektrischen und elektronischen Geräten mit einem in den Kantenbereichen (10) abgebogenen, mit Deckel (22) und Rückwand (21) versehenen Ober- und Unterteil (2, 3), die jeweils aus einem Strangpreßprofil bestehen, wobei das Strangpreßprofil am Ort der Kantenbereiche (10) quer zur Preßrichtung bis zur Grundmaterialstärke jeweils mit einem rechtwinkligen, V-förmigen Einschnitt (12) versehen ist und die Kantenbereiche (10) verschweißt oder unter Einsatz von Winkelstücken verschraubt sind, **dadurch gekennzeichnet, daß** das Strangpreßprofil mindestens einen Kühlmittelkanal (13) mit geschlossenem Querschnitt aufweist.

2. Container nach Anspruch 1, **dadurch gekennzeichnet, daß** das Strangpreßprofil mindestens einen Kabelkanal (14) mit zum Gehäuseinneren gerichteter Öffnung aufweist

3. Container nach einem der Ansprüche 1 oder 2, **dadurch gekennzeichnet, daß** das Strangpreßprofil einen umlaufenden deckelseitigen Dichtkragen (18) aufweist, welcher gegen Dichtmittel des Deckels (22) preßt.

4. Container nach einem der Ansprüche 1 bis 3, **dadurch gekennzeichnet, daß** das Strangpreßprofil einen rückwandseitigen umlaufenden Flansch (19) zur Befestigung und Abdichtung der Rückwand (21) aufweist.

5. Container nach einem der Ansprüche 1 bis 4, **dadurch gekennzeichnet, daß** das Strangpreßprofil mindestens eine Nut (16) zur Befestigung einer gehäuseinternen Zwischenwand aufweist.

6. Container nach einem der Ansprüche 1 bis 5, **dadurch gekennzeichnet, daß** das Strangpreßprofil mindestens einen Kanal (15) zur Aufnahme von Stromschienen aufweist.

7. Container nach einem der Ansprüche 1 bis 6, **dadurch gekennzeichnet, daß** das Strangpreßprofil eine deckelseitige Kante (17) zur Einhängung des Deckelscharniers aufweist.

8. Container nach einem der Ansprüche 1 bis 7, **dadurch gekennzeichnet, daß** jeweils U-förmig gestaltete Oberteile (2) und Unterteile (3) an den Stirnflächen ihrer Seitenflächen miteinander verbunden sind.

9. Container nach einem der Ansprüche 1 bis 7, **dadurch gekennzeichnet, daß** das Strangpreßprofil einstückig gebogen ist, wobei die Verbindung an deren Stirnflächen (11) erfolgt, wobei die Stirnflächen (11) vorzugsweise im Bereich der Seitenflächen (4,5) angeordnet sind.

## Claims

1. Container for a rail vehicle for the installation of electrical and electronic apparatuses, having an upper part and a lower part (2, 3) which are bent in the edge regions (10), are provided with a lid (22) and rear wall (21) and each consist of an extruded profile, the extruded profile being provided in each case with a right-angled, V-shaped incision (12) transverse to the pressing direction down to the thickness of the main material at the location of the edge regions (10), and the edge regions (10) being welded together or, with the insertion of angular components, being screwed together, **characterized in that** the extruded profile has at least one coolant duct (13) with a closed cross section.

2. Container according to Claim 1, **characterized in that** the extruded profile has at least one cable duct (14) having an opening directed towards the housing interior.

3. Container according to either of Claims 1 and 2, **characterized in that** the extruded profile has an encircling sealing collar (18) on the lid side, which presses against sealing means of the lid (22).

4. Container according to one of Claims 1 to 3, **characterized in that** the extruded profile has an encircling flange (19) on the rear-wall side for the fastening and sealing of the rear wall (21).

5. Container according to one of Claims 1 to 4, **characterized in that** the extruded profile has at least one groove (16) for the fastening of an intermediate wall internal to the housing.

6. Container according to one of Claims 1 to 5, **characterized in that** the extruded profile has at least one duct (15) for accommodating busbars.

7. Container according to one of Claims 1 to 6, **characterized in that** the extruded profile has an edge (17) on the lid side for the attachment of the lid hinge.

8. Container according to one of Claims 1 to 7, **characterized in that** upper parts (2) and lower parts (3), which are in each case of U-shaped design, are connected to one another on the end surfaces of their side surfaces.

9. Container according to one of Claims 1 to 7, **characterized in that** the extruded profile is integrally bent, with the connection taking place on its end surfaces (11), the end surfaces (11) preferably being arranged in the region of the side surfaces (4, 5).

## Revendications

1. Coffret pour un véhicule ferroviaire pour l'installation d'appareils électriques et électroniques, comprenant une partie supérieure et une partie inférieure (2, 3) recourbées dans les régions des bords (10), pourvues d'un couvercle (22) et d'une paroi arrière (21), qui se composent respectivement d'un profilé filé, le profilé filé étant pourvu, à l'endroit des régions des bords (10) transversalement à la direction de pressage jusqu'à l'épaisseur du matériau de base à chaque fois d'une entaille (12) rectangulaire en forme de V, et les régions des bords (10) étant soudées ou vissées en utilisant des pièces coudées, **caractérisé en ce que** le profilé filé présente au moins un conduit de réfrigérant (13) avec une section transversale fermée.

2. Coffret selon la revendication 1, **caractérisé en ce que** le profilé filé présente au moins un conduit de câble (14) avec une ouverture orientée vers l'intérieur du boîtier.

3. Coffret selon l'une quelconque des revendications 1 ou 2, **caractérisé en ce que** le profilé filé présente un rebord d'étanchéité (18) périphérique du côté du couvercle, lequel presse contre des moyens d'étanchéité du couvercle (22).

4. Coffret selon l'une quelconque des revendications 1 à 3, **caractérisé en ce que** le profilé filé présente une bride (19) périphérique du côté de la paroi arrière, pour la fixation et l'étanchéité de la paroi arrière (21).

5. Coffret selon l'une quelconque des revendications 1 à 4, **caractérisé en ce que** le profilé filé présente au moins une rainure (16) pour la fixation d'une paroi intermédiaire interne au boîtier.

6. Coffret selon l'une quelconque des revendications 1 à 5, **caractérisé en ce que** le profilé filé présente au moins un conduit (15) pour recevoir des rails conducteurs.

7. Coffret selon l'une quelconque des revendications 1 à 6, **caractérisé en ce que** le profilé filé présente une arête (17) du côté du couvercle, pour accrocher la charnière du couvercle.

8. Coffret selon l'une quelconque des revendications 1 à 7, **caractérisé en ce que** des parties supérieures (2) et des parties inférieures (3) respectivement en forme de U sont connectées les unes aux autres aux faces frontales de leurs faces latérales.

9. Coffret selon l'une quelconque des revendications 1 à 7, **caractérisé en ce que** le profilé filé est courbé d'une seule pièce, la connexion s'effectuant au niveau de ses faces frontales (11), les faces frontales (11) étant de préférence disposées dans la région des faces latérales (4, 5).
